# EUROPÄISCHE PATENTSCHRIFT

(11) **EP 1 090 303 B1**
(45) Veröffentlichungstag und Bekanntmachung des Hinweises auf die Patenterteilung: **12.01.2005**
(21) Anmeldenummer: 99926252.0
(22) Anmeldetag: 16.04.1999
(51) Int. Cl.: G01R 31/11, G01R 31/02

(54) **VERFAHREN UND VORRICHTUNG ZUR ÜBERWACHUNG EINER ELEKTRODENLEITUNG EINER BIPOLAREN HOCHSPANNUNGS-GLEICHSTROM-ÜBERTRAGUNGS-ANLAGE**
METHOD AND DEVICE FOR MONITORING AN ELECTRODE LINE OF A BIPOLAR HIGH VOLTAGE DIRECT CURRENT (HVDC) TRANSMISSION SYSTEM
PROCEDE ET DISPOSITIF POUR LA SURVEILLANCE D'UNE LIGNE D'ELECTRODE D'UNE INSTALLATION BIPOLAIRE DE TRANSPORT DE COURANT CONTINU A HAUTE TENSION (C.C.H.T)

(30) Priorität: 29.04.1998 DE 19819219
(43) Veröffentlichungstag der Anmeldung: 11.04.2001
(73) Patentinhaber: SIEMENS AKTIENGESELLSCHAFT, 80333 München (DE)
(72) Erfinder: AMMON, Jörg, D-91054 Erlangen (DE); PLEWKA, Gerhard, D-91083 Baiersdorf (DE); SCHALLER, Gerhard, D-91333 Hemhofen (DE)
(86) Internationale Anmeldenummer: PCT/DE1999/001144
(87) Internationale Veröffentlichungsnummer: WO 1999/056140

(56) Entgegenhaltungen:
- EP-A- 0 360 109
- DE-A- 4 425 551
- US-A- 5 083 086

## Beschreibung

Die Erfindung bezieht sich auf ein Verfahren und eine Vorrichtung zur elektrischen Überwachung einer Elektrodenleitung einer bipolaren Hochspannungs-Gleichstrom-Übertragungs-Anlage, bei der die Elektrodenleitung von einem Verzweigungspunkt an in zwei Leitungen aufgeteilt ist.

Anlagen zur Leistungsübertragung mittels eines hochgespannten Gleichstromes enthalten zwei Stromrichterstationen, die durch eine Gleichstromleitung miteinander verbunden sind. Bei einer sogenannten einpoligen Gleichstromübertragung sind die beiden Stationen mittels einer einzigen Gleichstromleitung miteinander verbunden, wobei der Rückstrom durch die Erde geleitet wird. Ein Gleichstrompol in jeder Station wird dann mittels eines guten Erdanschlusses geerdet. Normalerweise ist dieser Erdanschluß in einer gewissen Entfernung von der Stromrichterstation angeordnet und mittels einer elektrischen Leitung an die Station angeschlossen, welche als Elektrodenleitung bezeichnet wird. Es kann oft wünschenswert oder notwendig sein, den Erdanschluß in einer großen Entfernung von bis zu hundert Kilometern von der Station entfernt anzuordnen.

Bei einer sogenannten zweipoligen Gleichstromübertragung sind die Stationen durch zwei Gleichstromleitungen miteinander verbunden, so daß im normalen Betrieb der Gleichstrom nicht durch die Erde zurückgeführt zu werden braucht. Aus verschiedenen Gründen, u.a., um einen einpoligen Betrieb der Anlage im Falle eines Stromrichterausfalls zu ermöglichen, sind auch Stromrichterstationen in zweipoligen Gleichstromübertragungen mit einem Erdanschluß versehen, der mittels einer Elektrodenleitung an die Station angeschlossen ist.

Eine Elektrodenleitung ist gegenüber Erde isoliert und besteht normalerweise aus einem mehrdrähtigen, verseilten Leiter, der an Isolatoren aufgehängt ist. Obwohl die Spannung zwischen der Elektrodenleitung und Erde normalerweise klein ist im Verhältnis zu anderen Spannungen in der Anlage, begründet ein Erdfehler auf der Elektrodenleitung die Gefahr von Personenschäden oder Schäden an anderen Anlagenkomponenten, z.B. Korrosionsschäden. Es ist daher erforderlich, daß Erdfehler, einschließlich hochohmiger Erdfehler, und Leitungsbrüche schnell und zuverlässig entdeckt werden können.

Zur Feststellung von Erdfehlern auf einer Elektrodenleitung ist bereits vorgeschlagen, eine Differentialschutzanordnung zu verwenden. In einer solchen Schutzanordnung wird der Strom an beiden Enden der Elektrodenleitung gemessen, und eine Differenz zwischen den beiden gemessenen Strömen bedeutet, daß ein Erdfehler vorhanden ist. Eine solche Schutzanordnung hat jedoch verschiedene Nachteile. Sie erfordert eine Nachrichtenverbindung zwischen den beiden Enden der Elektrodenleitung und ist daher, besonders in Verbindung mit langen Elektrodenleitungen, teuer. Eine solche Schutzanordnung reagiert auch nicht auf einen Erdfehler, der in solchen Fällen auftritt, in den die Elektrodenleitung keinen Strom führt, was normalerweise in ungestörten Betrieb einer zweipoligen Übertragung der Fall ist. Auch in diesem Falle, d.h., wenn kein direkter Strom durch die Elektrodenleitung fließt, können Unsymmetrieströme zur Entstehung gefährlicher Spannungen auf der Leitung führen.

Es wurde ferner vorgeschlagen, Erdfehler auf einer Elektrodenleitung dadurch festzustellen, daß in der Stromrichterstation ein Wechselstromsignal oder ein Wechselspannungssignal bestimmter Frequenz in die Leitung eingespeist wird. In diesem Falle werden Unterdrückungsfilter an beiden Enden der Leitung angeordnet, wobei diese Filter auf die Frequenz des eingeleiteten Signals abgestimmt sind. Ein Impedanzmeßglied dient zur Messung der Impedanz der Elektrodenleitung gegenüber der Erde am Einspeisepunkt bei Einspeisungsfrequenz. Eine Änderung der so gemessenen Impedanz ist ein Anzeichen für einen Erdfehler. Dieses Verfahren arbeitet gut im Falle kurzer Elektrodenleitungen, zeigt jedoch Nachteile bei langen Elektrodenleitungen. Zur Erkennung eines Leitungsfehlers muß die Meßfrequenz so gewählt werden, daß die Länge der Leitung kleiner als ein Viertel der Wellenlänge ist. Aus diesem Grund muß im Falle langer Elektrodenleitungen eine so niedrige Frequenz gewählt werden, daß die Gefahr besteht, daß die Messung durch die Netzfrequenz oder durch die niedrigsten Oberwellen der Netzfrequenz gestört wird. Ferner werden bei diesen niedrigen Frequenzen die an beiden Enden der Elektrodenleitung angeordneten Unterdrückungsfilter, die für den maximalen Strom auf die Elektrodenleitung bemessen sein müssen, sehr groß und teuer.

In der EP 0 360 109 B1 ist eine Schutzvorrichtung für eine Elektrodenleitung der eingangs genannten Art angegeben, bei der auch im Falle langer Elektrodenleitungen eine hohe Meßfrequenz verwendet werden kann, wodurch die Abmessungen und Kosten der Unterdrückungsfilter sowie die Gefahr einer Störung durch die Netzfrequenz oder ihrer Oberwellen wesentlich vermindert wird. Zur Vermeidung von stehenden Wellen auf der Elektrodenleitung ist das Unterdrückungsfilter am, bezogen auf den Einspeisepunkt, fernen Ende der Elektrodenleitung mit Widerstandsgliedern versehen, die einen solchen Widerstandswert haben, daß das Filter der Wellenimpedanz der Elektrodenleitung angepaßt ist. Auf diese Weise wird vermieden, daß das Meßsignal am fernen Ende der Elektrodenleitung reflektiert wird.

Aus der US-PS 5,083,086 ist ein Verfahren zur Ortung einer Fehlerstelle in einem Kabel bekannt. Bei diesem Verfahren zur Fehlerortbestimmung rührt ein Instandsetzungs-Fachmann dieses Verfahren durch, wobei zunächst das fehlerhafte Kabel freigeschaltet wird, d.h., das Kabel ist nicht im Betrieb. Als nächstes wird an einem Ende des freigeschalteten Kabels eine Vorrichtung angeschlossen, mit der das Verfahren zur Fehlerortbestimmung durchgeführt wird. Diese Vorrichtung speist einen ersten elektrischen Impuls in das Kabel ein und zeichnet die empfangenen Reflexionen auf. Danach wird eine am freigeschalteten Kabel angeschlossene Spannung erhöht, ein zweiter Impuls in das Kabel eingespeist und die empfangenen Reflexionen aufgezeichnet. Durch die Erhöhung der Speisespannung verändert sich die Impedanz an der Fehlerstelle im Kabel, so daß eine Reflexion empfangen werden kann, die den Fehlerort eindeutig wiedergibt. Die aufgezeichneten Echosignale werden miteinander verglichen. Mittels diesem Differenzsignal und einer erfaßten Laufzeit kann dann der Fehlerort im Kabel berechnet werden.

Zur Erfassung des Zustandes einer Elektrodenleitung einer bipolaren Hochspannungs-Gleichstrom-Übertragungs-Anlage (HGÜ-Anlage) ist bereits ein Verfahren vorgeschlagen worden (Patentanmeldung mit dem amtlichen Aktenzeichen 196 50 974.2), bei dem ein erster elektrischer Impuls an einem ersten Ende ' der Elektrodenleitung eingespeist und ein Echosignal dieser Leitung erfaßt. Danach wird ein zweiter Impuls am ersten Ende in die Leitung eingespeist und dessen Echosignal erfaßt. Diese beiden Echosignale werden anschließend miteinander verglichen. Bei einer Abweichung und/oder einer Übereinstimmung zwischen den beiden Echosignalen wird ein entsprechendes Meldesignal erzeugt. Diese Verfahrensschritte werden fortlaufend wiederholt, bis ein Fehlersignal generiert wird. Mit diesem Meldesignal wird das Zustandserfassungs-Verfahren gestoppt. Anhand von aufgezeichneten Echosignalen kann der Fehlerort ermittelt werden. Ein Vergleich des fehlerbehafteten Echosignals mit abgespeicherten Echosignalen für unterschiedliche Betriebssituationen erlaubt eine schnellere Bestimmung des Fehlers (Erdschluß, Leitungsbruch,...).

Eine Vorrichtung zur Durchführung dieses vorgeschlagenen Verfahrens weist einen Impulsgenerator, eine Auswerteeinrichtung und ein Koppelglied auf. Über dieses Koppelglied wird der Impuls des Impulsgenerators in die Elektrodenleitung eingespeist und dessen Echosignal zur Auswerteeinrichtung weitergeleitet. Die Vorrichtung ist an einem ersten Ende der Elektrodenleitung angeschlossen. Das zweite Ende der Elektrodenleitung ist mit Erdpotential verbunden. Damit der elektrische Impuls nicht in die HGÜ-Anlage, sondern nur in das zu überwachende Teilstück der Elektrodenleitung läuft, ist endseitig die Elektrodenleitung mit Dämpfungsgliedern versehen. Die Auswerteeinrichtung umfaßt einen Vergleicher, einen Speicher und eine Auslöseeinrichtung. Der Impulsgenerator erzeugt synchron zu einem Zeittakt rechteckförmige, gleichanteilsbehaftete Impulse, die fortlaufend in die Elektrodenleitung eingespeist werden bis ein Fehlersignal vorliegt.

Dieses bereits vorgeschlagene Verfahren erlaubt eine einfache Fehlererkennung im Betrieb der HGÜ-Anlage, ohne daß vorhandene Meßsignale verwendet werden müssen. Das Verfahren arbeitet somit autark. Da im fehlerfreien Fall die Erde an der Leitung des Impulses beteiligt ist, beeinflussen schwankende Erdleitfähigkeiten die Echosignale und damit eine sichere Erkennung von Fehlern. Außerdem ist die Abstrahlung von elektromagnetischer Energie, verursacht durch den Impuls im Gleichtaktmode, recht hoch. Ein weiterer Nachteil besteht darin, daß an beiden Enden der Elektrodenleitung seriell in diese Elektrodenleitung Dämpfungsglieder geschaltet werden müssen. Dadurch wird der Aufwand für eine nachträgliche Installation bei einer bestehenden HGÜ-Anlage recht hoch.

Der Erfindung liegt die Aufgabe zugrunde, zur Überwachung einer Elektrodenleitung einer bipolaren HGÜ-Anlage ein Verfahren anzugeben, das die vorstehend erwähnten Nachteile nicht mehr aufweist, und eine zur Ausübung des Verfahrens geeignete Vorrichtung anzugeben.

Diese Aufgabe wird erfindungsgemäß gelöst mit den Merkmalen der Ansprüche 1 und 11.

Dadurch, daß bei dem neuen Verfahren aus einem unsymmetrischen Impulssignal ein symmetrisches Impulssignal im Gegentaktmode erzeugt und in die beiden Leitungen der Elektrodenleitung eingespeist wird, ist die Erde kaum mehr an der Übertragung dieser Impulse beteiligt, so daß das erfindungsgemäße Verfahren gegenüber einer stark schwankenden Erdleitfähigkeit nahezu unabhängig ist. Ein weiterer Vorteil besteht darin, daß die Abstrahlung in Form von elektromagnetischer Energie gegenüber einem Gleichtaktmode deutlich reduziert ist. Außerdem verursacht der Gegentaktmode eine geringe Leitungsdämpfung, so daß eine höhere Reichweite des Systems bei gleichzeitig kleinerer Dispersion des Echosignals erlaubt ist.

Der wichtigste Vorteil des Gegentaktmodes ist jedoch seine völlige Entkopplung zum Gleichtaktmode. Störsignale, die aus der HGÜ-Anlage kommen, können sich nur im Gleichtaktmode ausbreiten, da diesseits des Verzweigungspunktes die Elektrodenleitung zu einem einzigen Leiter zusammengefaßt ist und somit ein elektromagnetisches Feld nur zwischen diesem Leiter und Erde existieren kann. Aus der HGU-Anlage kommende Storsignale breiten sich nahezu mit Lichtgeschwindigkeit auf der Elektrodenleitung aus, werden am Verzweigungspunkt nahezu amplituden- und phasengleich aufgeteilt und wandern dann auf den beiden Wellenleitern, nämlich Leiter - Erde und Leiter - Erde, zum anlagenfernen Ende der Elektrodenleitung. Zwischen den vom Verzweigungspunkt in gleichen Abständen angebrachten Einspeiseanschlüssen können diese Störsignale jedoch keine Spannung erzeugen, weshalb sich eine ideale, frequenzunabhängige Entkopplung des Verfahrens zur Überwachung der Elektrodenleitung von der HGÜ-Anlage ergibt. Aufgrund der Reziprozität der Elektrodenleitung können andererseits keine Signale, die an den Einspeiseanschlüssen im Gegentaktmode eingespeist werden, in die HGÜ-Anlage gelangen, wodurch das Verfahren von zufälligen Schaltzuständen der HGÜ-Anlage unabhängig ist. Um ein Signal im Gegentaktmode in die Elektrodenleitung, bestehend aus zwei Leitungen, einspeisen zu können, muß der Kurzschluß für diesen Mode im Verzweigungspunkt unwirksam gemacht werden. Dies könnte beispielsweise dadurch bewerkstelligt werden, daß zwischen den Einspeiseanschlüssen und dem Verzweigungspunkt jeweils eine Spule großer Induktivität in Serie in die Elektrodenleitung geschaltet wird. Da im einpoligen Betrieb Ströme in der Größenordnung kA durch die Elektrodenleitung fließen, müßten die beiden dafür benötigten Spulen auch für diese Ströme ausgelegt werden.

Eine vorteilhafte Ausgestaltung des neuen Verfahrens sieht daher vor, die Einspeisung von Impulssignalen im Gegentaktmode ohne solche Bauelemente wie die erwähnten Spulen durchzuführen. Möglich ist dies, wenn die Einspeisepunkte sich in einem vorbestimmten Abstand vom Verzweigungspunkt befinden, wobei dieser Abstand so zu bemessen ist, daß sie etwa einem Viertel der Leitungswellenlänge bei der Mittenfrequenz des generierten erdunsymmetrischen Impulses entspricht. Bei dieser Frequenz transformiert sich der Kurzschluß im Verzweigungspunkt in einen Leerlauf an den Einspeiseanschlüssen, und bei benachbarten Frequenzen wird dieser Kurzschluß in eine hochohmige Reaktanz transformiert, die an den Einspeiseanschlüssen dem Wellenwiderstand der Leitung parallel geschaltet zu denken ist.

Ein weiterer Vorteil dieses Verfahrens besteht darin, daß sich dieses Überwachungsverfahren selbständig an die unterschiedlichen Betriebsbedingungen anpassen kann. Dies wird dadurch erreicht, daß eine Echodifferenzkurve in Abhängigkeit einer aufgezeichneten Ist-Echokurve und einer abgespeicherten, gebildeten dynamischen Soll-Echokurve erzeugt wird. Durch die Verwendung einer dynamischen, sich zeitlich veränderbaren Soll-Echokurve werden beispielsweise Einflüsse der Jahreszeiten auf die Elektrodenleitung in das Überwachungsverfahren miteingebunden, so daß jeweils eindeutig ein Fehlerfall ermittelt werden kann.

Wird ein Fehlersignal generiert, so kann das Überwachungsverfahren abgeschaltet werden. Dazu wird die Generierung von Impulsen unterbrochen bzw. abgeschaltet.

Bei einer vorteilhaften Ausgestaltung des neuen Verfahrens wird zusätzlich eine vorbestimmte statische Soll-Echokurve generiert und mit einem Toleranzband umhüllt, das aus einer oberhalb und einer unterhalb dieser statischen Soll-Echokurve verlaufenden Grenzkurve bestimmt wird. Eine gebildete dynamische Soll-Echokurve wird nun anhand dieser statischen Soll-Echokurve daraufhin überprüft, ob wenigstens eine Amplitude dieser dynamischen Soll-Echokurve außerhalb des Toleranzbandes der statischen Soll-Echokurve liegt. Trifft dies wenigstens einmal innerhalb eines vorgegebenen Zeitraumes zu, so wird ein Fehlersignal generiert und das Überwachungsverfahren abgeschaltet. Durch die Verwendung einer vorbestimmten statischen Soll-Echokurve können Defekte an der Vorrichtung zur Überwachung der Elektrodenleitung ermittelt werden, die, wenn sie schleichend auftreten, sonst unter eine sich zeitlich ändernde Betriebsbedingung fallen wurden.

Eine weitere vorteilhafte Ausgestaltung des neuen Verfahrens sieht vor, die dynamische Soll-Echokurve aus einem Mittelwert wenigstens zweier zeitlich aufeinander folgender Ist-Echokurven zu bilden. D.h., daß ständig aus einer vorbestimmten Anzahl von zeitlich aufeinanderfolgenden Ist-Echokurven ein Mittelwert gebildet und als dynamische Soll-Echokurve hinterlegt wird. Dadurch wird bei jeder neuen Ist-Echokurve ein neuer Mittelwert als dynamischer Soll-Echokurve hinterlegt. Dies geschieht jedoch nur dann, wenn bei der Auswertung einer Echodifferenzkurve kein Meldesignal generiert wurde.

Weitere vorteilhafte Ausgestaltungen des Verfahrens zur Überwachung einer Elektrodenleitung einer bipolaren HGÜ-Anlage sind in den Ansprüchen 4 und 5 sowie 7 bis 10 angegeben.

Dadurch, daß bei der zur Ausübung des neuen Überwachungsverfahrens vorgesehenen Vorrichtung neben einem Impuls-Echo-Überwachungsgerät, das einen Impuls-Generator und eine Empfängereinrichtung aufweist, eine Einspeisevorrichtung vorhanden ist, die ausgangsseitig jeweils mit einem Einspeiseanschluß der beiden Leitungen der Elektrodenleitung verknüpft ist, wird aus einem vom Impuls-Generator generiertem unsymmetrischen Impulssignal ein symmetrisches Impulssignal im Gegentaktmode erzeugt. Das Impuls-Echo-Überwachungsgerät ist mit den Eingängen der Einspeiseschaltung verknüpft. Diese Einspeiseschaltung weist eingangsseitig eine Einrichtung zur Impulsumwandlung und ausgangsseitig zwei Koppelkondensatoren auf, die jeweils die Ausgänge der Einrichtung zur Impulsumwandlung mit einem Einspeiseanschluß verbindet.

Durch die Ausgestaltung der Einspeisevorrichtung wird einerseits aus einem erdunsymmetrischen Impulssignal des Impuls-Generators ein symmetrisches Impulssignal im Gegentaktmode generiert, wodurch die bereits genannten Vorteile des Gegentaktmodes gegenüber einem Gleichtaktmode eintreten, und andererseits werden Störungen, die von der HGÜ-Anlage kommen, nur sehr stark gedämpft zur Empfängereinrichtung übertragen.

Bei einer vorteilhaften Ausgestaltung der Einspeiseschaltung ist als Einrichtung zur Impulsumwandlung ein Trennübertrager mit einer Niederspannungs- und Hochspannungswicklungen, zwei Spulen und zwei Ableitern vorgesehen, wobei jeweils eine Spule und ein Ableiter elektrisch parallel zu einer Hochspannungswicklung geschaltet sind. Der Verbindungspunkt der beiden Hochspannungswicklungen ist mit Erdpotential verbunden. Die beiden Koppelkondensatoren bilden mit den beiden Spulen zwei Hochpaßfilter, die jeweils auf die Mittenfrequenz des generierten Impulses abgestimmt sind. Die Ableiter schützen den Trennübertrager bei transienten Störungen (Blitzeinschlag, Schaltstoß) vor Überspannungen.

Gemäß einer weiteren vorteilhaften Ausgestaltung der neuen Vorrichtung weist der Impuls-Generator zwei Spannungsquellen, zwei Kondensatoren, zwei Schalter, zwei Widerstände und eine Betätigungseinrichtung für die Schalter auf, wobei jeder Kondensator mittels eines Widerstandes mit einer Spannungsquelle elektrisch leitend verbunden ist. Ein Verbindungspunkt dieser beiden Kondensatoren und ein Verbindungspunkt der beiden Spannungsquellen sind jeweils mit Erdpotential verbunden. Die Kondensatoren sind jeweils mittels eines Schalters mit dem Ausgang des Impuls-Generators verknüpfbar, wobei die Betätigungseinrichtung mit einem Steuer-Ausgang des Impuls-Generators verbunden ist. - Mit Hilfe eines solchen Impuls-Generators wird auf einfache Weise ein gleichanteilsfreier, schmalbandiger, rechteckförmiger Impuls mit hohem Spektralanteil bei seiner Mittenfrequenz erzeugt.

Prinzipiell können für das neue Überwachungsverfahren auch andere Impulsformen verwendet werden, die die bereits genannten spektralen Eigenschaften besitzen. Beispielsweise kann ein symmetrisch zur Zeitachse verlaufender Sägezahnimpuls e-benfalls verwendet werden. Die Erzeugung eines derartigen Impulses ist jedoch aufwendiger.

Gemäß einer weiteren vorteilhaften Ausgestaltung der neuen Vorrichtung weist die Empfängereinrichtung eine Vorrichtung zur Echtzeit-Aufzeichnung von Echosignalen, eine Recheneinheit, einen Hauptspeicher und eine Eingangs- und Ausgangsschnittstelle auf, wobei der Steuer-Eingang dieser Einspeiseeinrichtung mit einem Steuer-Eingang der Vorrichtung zur Echtzeit-Aufzeichnung von Echosignalen verbunden ist. Die Recheneinheit ist mit dem Hauptspeicher, der Vorrichtung zur Echtzeit-Aufzeichnung und mit den Schnittstellen verknüpft. Eine Signal-Eingang der Vorrichtung zur Echtzeit-Aufzeichnung ist mit dem Eingang der Empfängereinrichtung verbunden, wobei eine übergeordnete Anlagen-Steuerung ein- und ausgangsseitig mit der Aus- und Eingangsschnittstelle verknüpft ist.

Durch die Verbindung des Steuer-Ausgangs des Impuls-Generators mit dem Steuer-Eingang der Vorrichtung zur Echtzeit-Aufzeichnung wird diese Vorrichtung auf die Aussendung von Impulsen des Impuls-Generators getriggert. Somit können die Echosignale für eine vorbestimmte Zeit aufgezeichnet werden, d.h., dieser Teil der Empfängereinrichtung wird online betrieben. Die weitere Bearbeitung dieser aufgezeichneten Echosignale erfolgt offline, wobei die Abwicklung dieser weiteren Bearbeitung zentral in der Recheneinheit abgewickelt wird.

Bei der neuen Vorrichtung sind die Einspeiseanschlüsse der Leitungen der Elektrodenleitung zweckmäßig jeweils in einem Abstand von einem Verzweigungspunkt der Elektrodenleitung angeordnet, wobei dieser Abstand insbesondere gleich einem Viertel der Wellenlänge der Freiraumwellenlänge bei Mittenfrequenz des Impulses ist. Durch die Wahl des Abstandes dieser Einspeiseanschlüsse vom Verzweigungspunkt müssen keinerlei Schaltungselemente seriell in die Elektrodenleitung geschaltet werden.

Für die Mittenfrequenz des Einspeiseimpulses transformiert sich der Kurzschluß im Verzweigungspunkt der Elektrodenleitung über die λ/4-lange Leitung in einen Leerlauf an der Einspeisestelle. Für diese Frequenz ist also die λ/4-lange Leitung mit samt der gesamten HGÜ-Anlage elektrisch nicht vorhanden. Der eingespeiste Impuls sieht bei dieser Frequenz lediglich den Wellenwiderstand der beiden Leitungen der Elektrodenleitung die zur Erdelektrode und zum Verzweigungspunkt führen. Bei anderen Frequenzen transformiert sich der Kurzschluß im Verzweigungspunkt über die dann nicht mehr λ/4-lange Leitung in eine Reaktanz, die an der Einspeisestelle dem Wellenwiderstand der Leitung parallel geschaltet zu denken ist.

Durch die Ausnutzung anlagenseitiger Gegebenheiten sowie durch die Anregung des Gegentaktmodes sind keinerlei zusätzliche Schaltungsmaßnahmen zur Entkopplung der Meßanordnung von der Station erforderlich. Somit kann auf die teuren Dämpfungsglieder verzichtet werden.
Weitere vorteilhafte Ausgestaltungen der Vorrichtung zur Überwachung einer Elektrodenleitung einer bipolaren HGÜ-Anlage sind den Unteransprüchen 13 bis 19 zu entnehmen.

Zur näheren Erläuterung der Erfindung wird auf die Zeichnung Bezug genommen, in der ein Ausführungsbeispiel der erfindungsgemäßen Vorrichtung schematisch dargestellt ist.
- FIG 1: zeigt eine erfindungsgemäße Vorrichtung mit einer Elektrodenleitung einer bipolaren HGÜ-Anlage, die
- FIG 2: zeigt ein Prinzipschaltbild des Impuls-Generators der Vorrichtung nach FIG 1, wobei in
- FIG 3: in einem Diagramm über der Zeit t ein generierter Impuls veranschaulicht ist, die
- FIG 4: zeigt ein Prinzipschaltbild der Empfängereinrichtung der Vorrichtung nach FIG 1, in
- FIG 5: ist in einem Diagramm über Zeit t eine aufgezeichnete Ist-Echokurve einer fehlerfreien Elektrodenleitung dargestellt, wobei in der
- FIG 6: in einen Diagramm über der Zeit t eine Echodifferenzkurve bei einem Leiter-Erd-Fehler auf der Elektrodenleitung veranschaulicht ist und die
- FIG 7: zeigt in einen Diagramm über der Zeit t eine statische Soll-Echokurve mit zugehörigem Toleranzband.

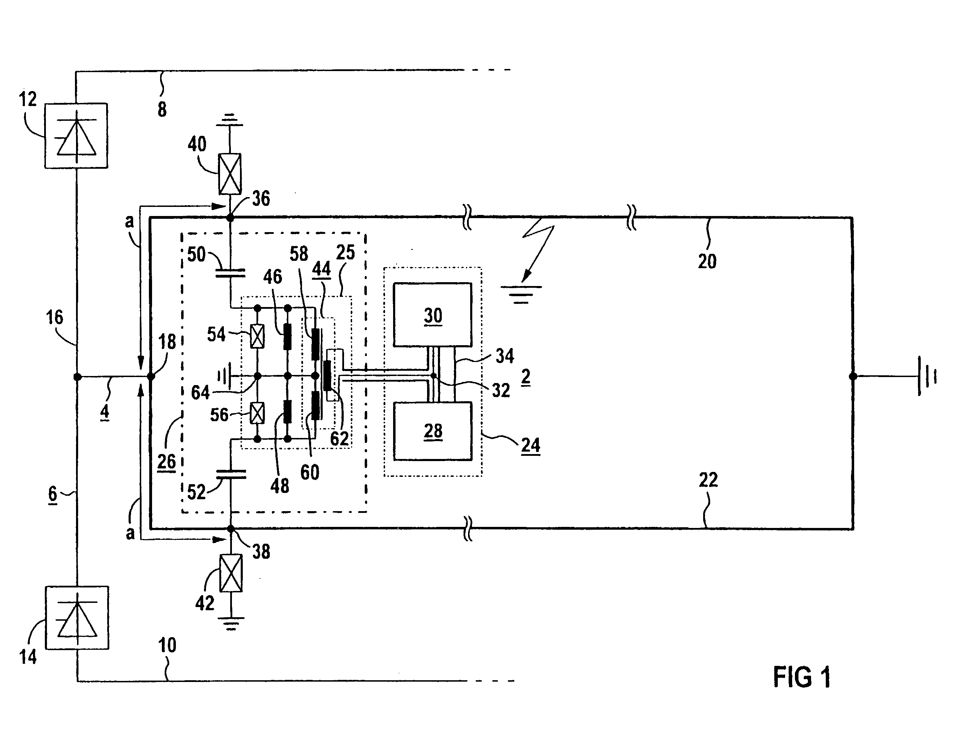

Die FIG 1 zeigt eine erfindungsgemäße Vorrichtung 2 zur Überwachung einer Elektrodenleitung 4 einer bipolaren Hochspannungs-Gleichstrom-Übertragungs-Anlage, von der der Übersichtlichkeit halber nur eine Stromrichterstation 6 dargestellt ist. Bei einer bipolaren HGÜ-Anlage, die auch als zweipolige Gleichstromübertragung bezeichnet wird, sind die beiden Stromrichterstationen durch zwei Gleichstromleitungen 8 und 10 miteinander verbunden und jede Station weist zwei Stromrichter 12 und 14 auf, die mittels eines Verbindungsbusses 16 elektrisch in Reihe geschaltet sind. Im normalen Betrieb dieser bipolaren HGÜ-Anlage wird der Gleichstrom nicht durch die Erde zurückgeführt. Aus verschiedenen Gründen, u.a., um einen einpoligen Betrieb der Anlage im Falle eines Stromrichterausfalls zu ermöglichen, sind auch die Stromrichterstationen in zweipoligen Gleichstromübertragungen mit einem Erdanschluß versehen, der mittels der Elektrodenleitung 4 an der Station 6 am Verbindungsbus 16 angeschlossen ist. Diese Elektrodenleitung 4 ist gegenüber Erde isoliert und besteht normalerweise aus einer Leitung, die an Isolatoren aufgehängt ist. Die hier dargestellte Elektrodenleitung 4 ist vom Verzweigungspunkt 18, dem sogenannten Splitting Point in zwei Leitungen 20 und 22 aufgespalten, die am Ende mit Erdpotential verknüpft sind. Diese Leitungen 20 und 22 der Elektrodenleitung 4 können gegebenenfalls bis 100 km lang sein. Die hier nicht näher dargestellte zweite Stromrichterstation der bipolaren HGÜ-Anlage ist ebenfalls mit einer Elektrodenleitung ausgestattet, d.h., die HGÜ-Anlage ist spiegelsymmetrisch aufgebaut.

In der Elektrodenleitung 4 fließt im fehlerfreien Betrieb also im symmetrischen Betrieb - nahezu kein Strom. Obwohl die Spannung zwischen der Elektrodenleitung 4 und Erde normalerweise klein ist im Verhältnis zu anderen Spannungen in der Anlage, begründet ein Erdfehler auf der Elektrodenleitung 4 die Gefahr von Personenschäden oder Schäden an anderen Anlagekomponenten. Aus diesem Grund ist es erforderlich, daß Erdfehler, einschließlich hochohmiger Erdfehler, schnell und zuverlässig entdeckt werden können. Außerdem ist für den sicheren Betrieb dieser bipolaren HGÜ-Anlage wichtig, auch den Zustand dieser Elektrodenleitung 4 zu kennen. Bei einem Leitungsbruch und einem fehlerhaften Betrieb der HGÜ-Anlage wäre dann ein unsymmetrischer Betrieb dieser zweipoligen HGÜ-Anlage nicht mehr möglich.

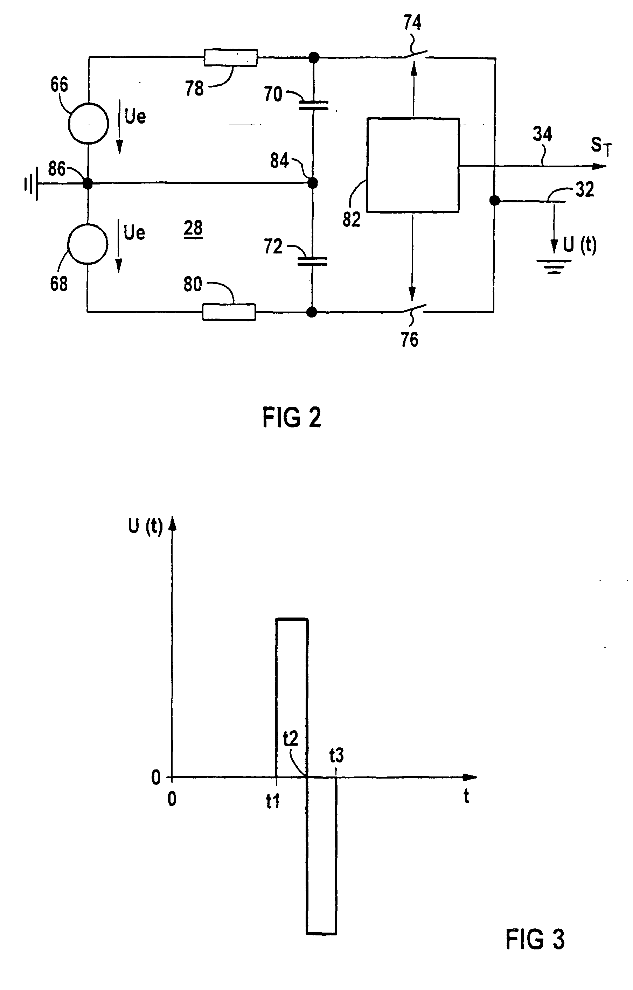

Zur Überwachung der Elektrodenleitung 4, bestehend aus zwei Leitungen 20 und 22, ist die Vorrichtung 2 nach der Erfindung vorgesehen. Diese Vorrichtung 2 weist ein Impuls-Echo-Überwachungsgerät 24 und eine Einspeisevorrichtung 26 auf. Dieses Impuls-Echo-Überwachungsgerät 24 besteht aus einem Impuls-Generator 28 und einer Empfängereinrichtung 30. Der Impuls-Generator 28, von dem eine vorteilhafte Ausführungsform näher in der FIG 2 dargestellt ist, ist mittels eines Koaxialkabels 32 mit Eingangs-Anschlüssen der Einspeisevorrichtung 26 verknüpft. Diese Anschlüsse der Einspeisevorrichtung 26 sind außerdem mit Eingangsanschlüssen der Empfängereinrichtung 30 verbunden. Um ein möglichst störungsarmes Signal zu gewährleisten, sollte dieses Koaxialkabel 32 doppelt geschirmt sein. Außerdem ist ein Steuer-Ausgang des Impuls-Generators 28 mit einem Steuer-Eingang der Empfängereinrichtung 30 mittels einer Steuerleitung 34 verknüpft. Die Einspeisevorrichtung 26 ist ausgangsseitig jeweils mit einem Einspeiseanschluß 36 und 38 der Leitungen 20 und 22 der Elektrodenleitung 4 verbunden. Diese Einspeiseanschlüsse 36 und 38 sind vom Verzweigungspunkt 18 beabstandet angeordnet, wobei dieser Abstand a näherungsweise λ/4 entspricht, wobei λ die Freiraumwellenlänge bei der Mittenfrequenz eines generierten Impulses u(t) des Impulsgenerators 28 darstellt. Außerdem sind diese Einspeiseanschlüsse 36 und 38 jeweils mittels eines Ableiters 40 und 42 mit Erdpotential verbünden. Diese beiden Ableiter 40 und 42 schützen die Einspeisevorrichtung 26 hochspannungsseitig vor transienten Störungen (Blitzeinschlag).

Die Einspeisevorrichtung 26 weist eingangsseitig eine Einrichtung 25 zur Impulsumwandlung und ausgangsseitig zwei Koppelkondensatoren 50 und 52 auf. Die Einrichtung 25 zur Impulsumwandlung weist einen Trennübertrager 44, zwei Spulen 46 und 48 und zwei Ableiter 54 und 56 auf. Dieser Trennübertrager 44 besteht aus zwei Hochspannungswicklungen 58 und 60 und einer Niederspannungswicklung 62. Der Verbindungspunkt 64 der beiden Hochspannungswicklungen 58 und 60 sind mit Erdpotential verbunden. Die beiden Anschlüsse der Niederspannungswicklung 62 bilden die Anschlüsse der Einspeisevorrichtung 26, an denen das Koaxialkabel 32 angeschlossen ist. Die Spule 46 bzw. 48 ist elektrisch parallel zur Hochspannungswicklung 58 bzw. 60 geschaltet. Außerdem ist der Ableiter 54 bzw. 56 elektrisch parallel zur Hochspannungswicklung 58 bzw. 60 des Trennübertragers 44 geschaltet. Der Koppelkondensator 50 bzw. 52 verbindet den Einspeisepunkt 36 bzw. 38 mit dem einen Anschluß der Hochspannungswicklung 58 bzw. 60. Diese beiden Koppelkondensatoren 50 und 52 übernehmen die Ankopplung der Einspeisevorrichtung 26 an das Hochspannungspotential der E-lektrodenleitung 4. Deshalb müssen diese Koppelkondensatoren 50 und 52 für das entsprechende Hochspannungsniveau der Elektrodenleitung 4 ausgelegt sein. Die beiden symmetrisch zum Erdpotential angeordneten Spulen 46 und 48 bilden zusammen mit den beiden Koppelkondensatoren 50 und 52 jeweils ein Hochpaßfilter. Diese Hochpaßfilter blocken die von der Elektodenleitung 4 kommenden niederfrequenten Störungen, d.h., charakteristische Stromoberschwingungen, die von der HGÜ-Anlage erzeugt werden und bei unsymmetrischem Betrieb der HGÜ-Anlage auch durch die Elektrodenleitung 4 fließen, ab. Die Ableiter 54 und 56 schützen die Hochspannungswicklungen 58 und 60 des Trennübertragers 44 bei transienten Störungen (Blitzeinschlag, Schaltstoß) vor Überspannungen. Diese Ableiter 54 und 56 sind für eine viel kleinere Spannung dimensioniert als die Ableiter 40 und 42. Der Trennübertrager 44 sorgt für eine Impedanzanpassung des Wellenwiderstandes des Koaxialkabels 32 an den Wellenwiderstand der Leitung 20 und 22 der Elektrodenleitung 4. Außerdem stellt dieser Trennübertrager 44 einen Symmetrierübertrager dar, der aus einem vom Impulsgenerator generierten unsymmetrischen Impulssignal ein symmetrisches Impulssignal im Gegentaktmode erzeugt.

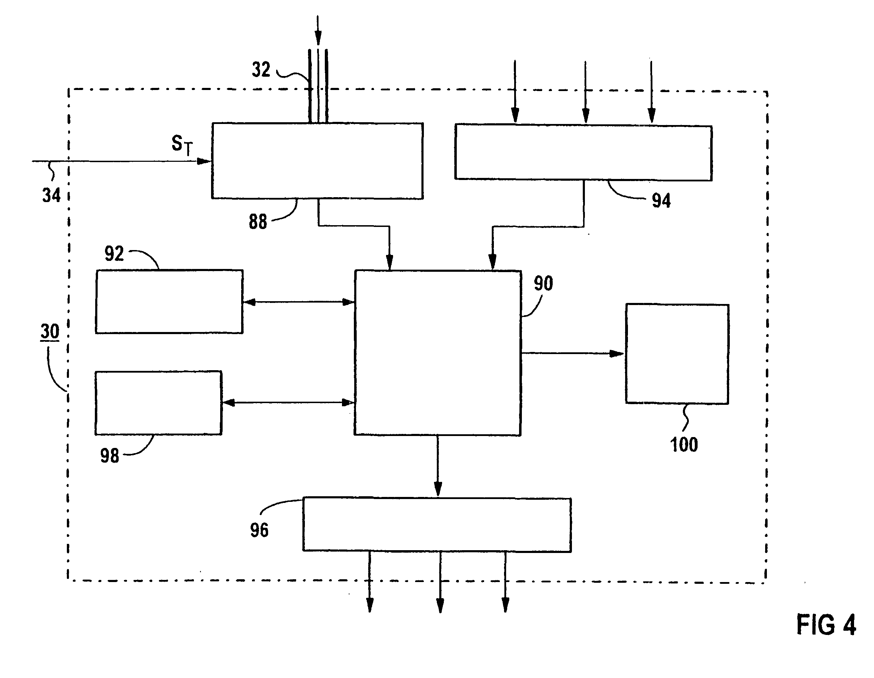

Die FIG 2 zeigt ein Prinzipschaltbild des Impuls-Generators 28 des Impuls-Echo-Überwachungsgeräts 24 nach FIG 1. Dieser Impuls-Generator 28 weist zwei Spannungsquellen 66 und 68, zwei Kondensatoren 70 und 72, zwei Schalter 74 und 76, zwei Widerstände 78 und 80 und eine Betätigungseinrichtung 82 für die Schalter 74 und 76 auf. Der Kondensator 70 bzw. 72 ist mittels des Widerstandes 78 bzw. 80 mit der Spannungsquelle 66 bzw. 68 elektrisch leitend verbunden. Der Verbindungspunkt 84 der beiden Kondensatoren 70 und 72 ist mit dem Verbindungspunkt 86 der beiden Spannungsquellen 66 und 68 verbunden, der außerdem mit Erdpotential verbunden ist. Mit den Widerstanden 78 und 80 wird der Ladestrom der Kondensatoren 70 und 72 eingestellt. Diese Kondensatoren 70 und 72 sind jeweils mittels der Schalter 74 und 76 mit dem Ausgang des Impuls-Generators 28 verbindbar, an dem das Koaxialkabel 32 angeschlossen ist. Als Schalter 74 und 76 sind elektronische Schalter, beispielsweise Transistoren, vorgesehen. Abhängig von der Wahl der elektronischen Schalter ist die Ausgestaltung der Betätigungseinrichtung 82. Außerdem sind die Schaltfrequenz der Schalter 74 und 76 und die Ladezyklen voneinander abhängig. Wenn die Kondensatoren 70 und 72 geladen sind, wird zum Zeitpunkt t₁ zuerst der Schalter 74 für eine vorbestimmte Zeitspanne t₂-t₁ geschlossen. Nach Ablauf dieser Zeitspanne t₂-t₁ wird dieser Schalter 74 geöffnet und gleichzeitig der Schalter 76 geschlossen. Nach einer weiteren vorbestimmten Zeitspanne t₃-t₂ wird dieser Schalter 76 wieder geöffnet. Danach werden beide Kondensatoren 70 und 74 mittels der Spannungsquelle 66 und 68 wieder aufgeladen, um den nächsten Impuls u(t), wie er in der FIG 3 in einem Diagramm über der Zeit t dargestellt ist, zu generieren. Mit dem Schließen des ersten Schalters 74 zum Zeitpunkt t₁ sendet die Betätigungseinrichtung 80 ein Trigger-Signal S_{T} mittels der Steuerleitung 34 zum Steuer-Eingang der Empfängereinrichtung 30, die in der FIG 4 näher dargestellt ist.

Der generierte Impuls u(t) gemäß FIG 3 ist symmetrisch zur Zeitachse t, d.h., er weist keinen Gleichanteil auf. Außerdem weist dieser Impuls u(t) bei seiner Mittenfrequenz einen ausgeprägten Spektralanteil auf. Die Höhe dieser Mittenfrequenz hängt davon ab, ob beispielsweise auf der Elektrodenleitung 4 Daten übertragen werden oder ob die Elektrodenleitung 4 in der Nähe von Energieleitungen verlegt ist, auf denen zusätzlich eine Datenübertragung stattfindet. Eine derartige Datenübertragung findet im allgemeinen in einem Frequenzbereich von beispielsweise 30 kHz bis 500 kHz statt. Wenn die Impuls-Breite des generierten Impulses u(t) entsprechend schmal gewählt wird, liegt dessen Mittenfrequenz über 500 kHz. Bei einer Impuls-Breite entsprechend dem Reziprok der Impulsdauer t₃-t₁ von beispielsweise 2 µs beträgt die Mittenfrequenz 500 kHz. D.h., die Impuls-Breite des generierten Impulses u(t) sollte kleiner als 2 µs sein. Da dieser Impuls nur geringe Spektralanteile unterhalb seiner Mittenfrequenz aufweist, ist eine Störung von Datenübertragungseinrichtungen annähernd Null. Prinzipiell können auch andere Impulsformen verwendet werden. Bei der Wahl von anderen Impulsformen sollte jedoch darauf geachtet werden, daß möglichst kein Gleichanteil vorhanden ist und daß ein ausgeprägter Spektralanteil bei einer Mittenfrequenz vorliegt. Mit diesen Bedingungen kann insbesondere der Impuls u(t) gemäß FIG 3 aufwendungsarm mit einem hohen Wirkungsgrad generiert werden. Die Forderung, daß möglichst der Impuls keinen Gleichanteil aufweisen sollte, ist darin begründet, daß der Trennübertrager 44 der Einspeisevorrichtung 26 keinen Gleichanteil im Frequenzspektrum des Impulses u(t) übertragen kann.

Die FIG 4 zeigt ein Prinzipschaltbild der Empfängereinrichtung 30 nach FIG 1. Diese Empfängereinrichtung 30 weist eine Vorrichtung 88 zur Echtzeit-Aufzeichnung von Echosignalen, eine Recheneinheit 90, einen Hauptspeicher 92 und eine Eingangs- und Ausgangsschnittstelle 94 und 96 auf. Außerdem weist dieser Empfängereinrichtung 30 noch einen Dokumentationsspeicher 98 und einen Bildschirm 100 auf. Der Eingang der Vorrichtung 88 zur Echtzeit-Aufzeichnung von Echosignalen ist mit dem Eingangs-Anschluß der Empfängereinrichtung 30 verknüpft, an dem das Koaxialkabel 32 angeschlossen ist. Außerdem ist ein Steueranschluß dieser Vorrichtung 88 mit dem Steuer-Eingang der Empfängereinrichtung 30 verbunden, mit dem die Steuerleitung 34 verbunden ist. Ausgangsseitig ist diese Vorrichtung 88 zur Echtzeit-Aufzeichnung mit der Recheneinheit 90 verknüpft, die außerdem derartig mit dem Hauptspeicher 92 und dem Dokumentationsspeicher 98 verknüpft ist, daß Daten ausgetauscht werden können. Eingangsseitig ist diese Recheneinheit 90 noch mit der Eingangsschnittstelle 94, insbesondere eine binäre Eingangsschnittstelle, und ausgangsseitig mit dem Bildschirm 100 und der Ausgangsschnittstelle 96, insbesondere eine binäre Ausgangsschnittstelle, verknüpft. Mittels dieser beiden Schnittstellen 94 und 96 ist die Empfängereinrichtung 30 mit einer übergeordneten Anlagen-Steuerung, die nicht näher dargestellt ist, verbunden. Von dieser Anlagen-Steuerung, die ein Teil einer Leittechnik der HGÜ-Anlage ist, erhält die Empfängereinrichtung 30 Betriebs- und Einstellparameter. Mittels der Ausgangsschnittstelle 96 gelangt ein generiertes Meldesignal bzw. Zustandssignale zur Leittechnik.

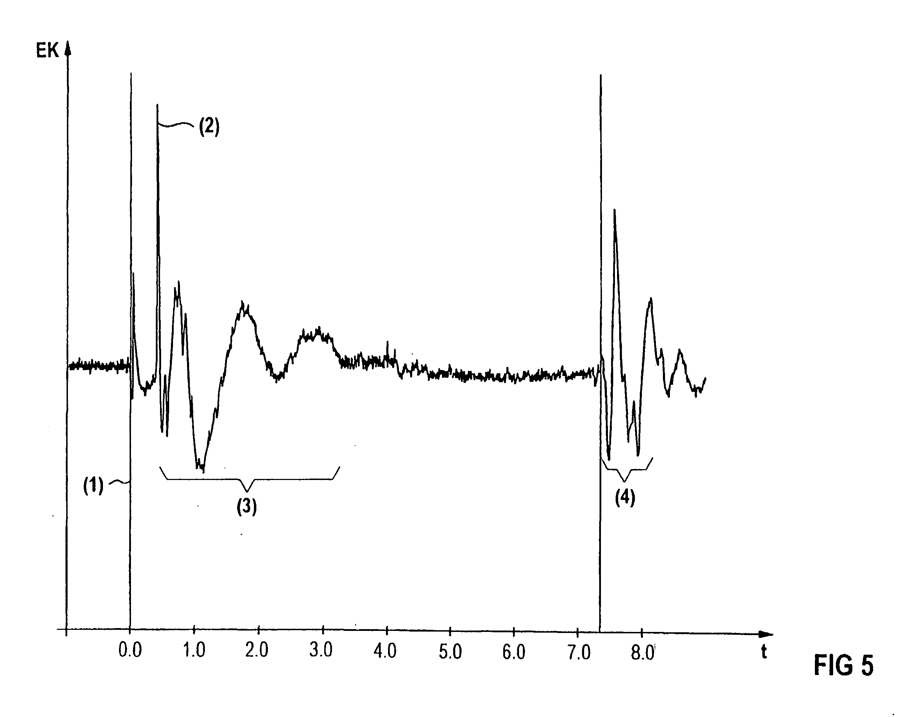

Die Vorrichtung 88 zur Echtzeit-Aufzeichnung von Echosignalen besteht aus einem Analog-Digital-Wandler und einem Speicher, insbesondere einem Schreib-Lese-Speicher, der dem A/D-Wandler nachgeschaltet ist. Dieser A/D-Wandler wird mittels des Trigger-Impulses S_{T} vom Impuls-Generator 28 gestartet, d.h., der A/D-Wandler beginnt mit der Digitalisierung der analogen Eingangssignale, d.h., der einlaufenden Echosignale. Diese digitalen Abtastwerte werden nach der Digitalisierung abgespeichert. Diese beiden Komponenten der Vorrichtung 88 arbeiten online, d.h., die eingehenden Echosignale werden in Echtzeit verarbeitet. Die Höhe der Abtastfrequenz des A/D-Wandlers und die Schnelligkeit der Abspeicherung der digitalen Abtastwerte hängt davon ab, wie lang die Elektrodenleitung 4 ist. Das bedeutet, daß durch die Länge der Elektrodenleitung 4 die Echolaufzeit bestimmt wird und damit der Zeitbereich festgelegt ist, der für eine Auswertung interessant ist. Außerdem ist die Höhe der Abtastfrequenz auch von der Speicherkapazität abhängig. Diese abgespeicherten Abtastwerte bilden als Zeitfunktion eine Ist-Echokurve EK gemäß der FIG 5.

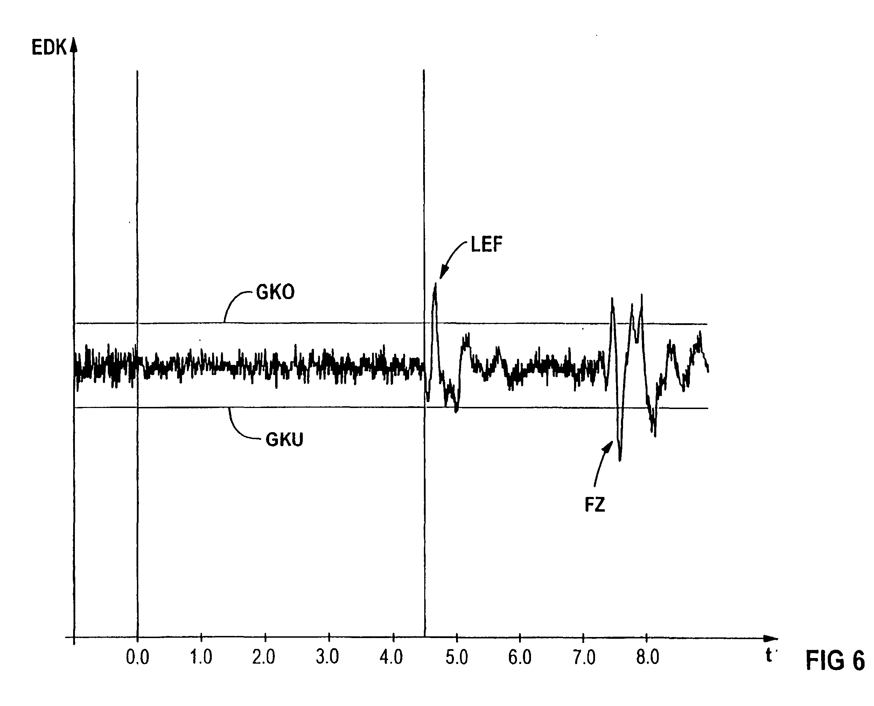

Die weitere Verarbeitung dieser echtzeitermittelten Ist-Echokurve erfolgt nun offline. Dazu werden diese digitalisierten Abtastwerte in den Hauptspeicher 92 kopiert. Außerdem können diese Abtastwerte auf den Bildschirm 100 grafisch dargestellt werden, d.h., die in der FIG 5 dargestellte Ist-Echokurve EK erscheint auf dem Bildschirm 100. Diese Ist-Echokurve EK wird mittels der Recheneinheit 90 mit einer im Hauptspeicher 92 abgelegten dynamischen Soll-Echokurve verglichen, d.h., es wird eine Echodifferenzkurve EDK berechnet, wie sie beispielsweise in der FIG 6 in einem Diagramm über der Zeit t dargestellt ist. Diese Echodifferenzkurve EDK wird mit einer oberhalb und unterhalb dieser Echodifferenzkurve EDK verlaufenden konstanten Grenzkurven GKO und GKU versehen. Diese beiden Grenzkurven GKO und GKU bilden somit ein Toleranzband, das zur Auffindung von Fehlerstellen verwendet wird.

Die Ist-Echokurve EK gemäß der FIG 5 zeigt, daß im fehlerfreien Fall der Impuls am Ende der Elektrodenleitung 4 definiert reflektiert wird. Das Echo wird zurückgeworfen und wird am Empfänger im Zeitbereich dargestellt bzw. ausgewertet. Es entsteht beispielsweise diese dargestellte Ist-Echokurve EK, die die Impulsantwort des Gesamtsystems (Koaxialkabel 32, Einspeisevorrichtung 26 und fehlerfreie Elektrodenleitung 4) darstellt. Diese Ist-Echokurve EK stellt quasi einen Fingerabdruck des fehlerfreien Systems dar. In der FIG 5 ist eine typische Ist-Echokurve EK einer ca. 7,4 km langen fehlerfreien Elektrodenleitung 4 dargestellt. Die zugehörige Zeitachse t dieses Diagramms ist in Entfernungskilometern parametriert. Bei dieser Ist-Echokurve EK können mehrere Bereiche unterschieden werden. Diese Bereiche sind durchnumeriert, die im folgenden aufgeführt sind:
a) Einspeiseimpuls (1)
b) Reflexion am Trennübertrager 44 (2)
c) Ein- bzw. Ausschwingvorgang der Einspeisevorrichtung (3)
d) definierte Reflexion vom Ende der Elektrodenleitung (4)

Tritt nun ein Fehler auf der Elektrodenleitung 4 auf (Leiter-Erd-Fehler oder Leitungsbruch) so entsteht ein zusätzliches Echo von der Fehlerstelle. Dies führt zu einer Veränderung der Ist-Echokurve EK. Gemäß der Darstellung der FIG 6 ist ein Leiter-Erd-Fehler in ca. 4,5 km vom Einspeisepunkt 36,38 entfernt und erzeugt ein deutliches Echo bzw. einen Ausschlag LEF. Gleichzeitig wird die definierte Ist-Echokurve EK vom Ende der Elektrodenleitung ebenfalls verzerrt, was sich bei der Differenzkurve als ein zweiter Ausschlag FZ abbildet. Der zeitlich näher liegende erste Ausschlag LEF stammt immer von der Fehlerstelle und ist für die Fehlerortbestimmung heranzuziehen, falls dies als Angabe gewünscht wird. Aus der Form bzw. aus der Stärke des von der Fehlerstelle reflektierten Echos lassen sich im allgemeinen auch Rückschlüsse auf die Fehlerart (Leiter-Erd-Fehler oder Leitungsbruch) ziehen. Für eine dauerhafte Überwachung der Elektrodenleitung 4 auf Fehler reicht es aber aus, die Echodifferenzkurve EDK generell auf Ausschläge LEF hin zu überwachen, die außerhalb des Toleranzbandes liegen.

Wie bereits erwähnt, wird zur Ermittlung der Echodifferenzkurve EDK eine dynamische Soll-Echokurve verwendet. Diese Soll-Echokurve wird aus wenigstens zwei zeitlich aufeinanderfolgenden aufgezeichneten Ist-Echokurven EK₁ und EK₂ gebildet, indem aus diesen beiden Kurven EK₁ und EK₂ eine Mittelwert-Echokurve gebildet wird, die dann als Soll-Echokurve abgespeichert wird. Diese Berechnung wird dynamisch fortgesetzt, d.h., daß eine neue Ist-Echokurve EK₃ zur Berechnung einer neuen Soll-Echokurve verwendet wird, wobei die erste Ist-Echokurve EK₁ nicht mehr verwendet wird. Eine derartige Berechnung kann mit Hilfe eines Schieberegisters durchgeführt werden, wobei immer eine neue Kurve eingelesen und die zeitlich älteste Kurve ausgelesen wird. Aus den Kurven, die im Schieberegister eingelesen sind, wird die Mittelwert-Echokurve berechnet. Somit wird nach jedem Trigger-Impuls S- eine neue dynamische Soll-Echokurve berechnet. Diese Berechnung wird erst dann begonnen, wenn der Vergleich einer aktuellen Ist-Echokurve mit einer aktuellen Soll-Echokurve einen fehlerfreien Zustand signalisiert. Mittels Einstellparameter wird festgelegt, wie viele Ist-Echokurven zur Berechnung einer dynamischen Soll-Echokurve verwendet werden sollen.

Durch diese Verwendung einer dynamisch, sich zeitlich veränderbaren Soll-Echokurve werden beispielsweise Einflüsse der Jahreszeiten auf die Elektrodenleitung 4 in das Überwachungsverfahren mit eingebunden, so daß eindeutig ein Fehlerfall ermittelt werden kann.

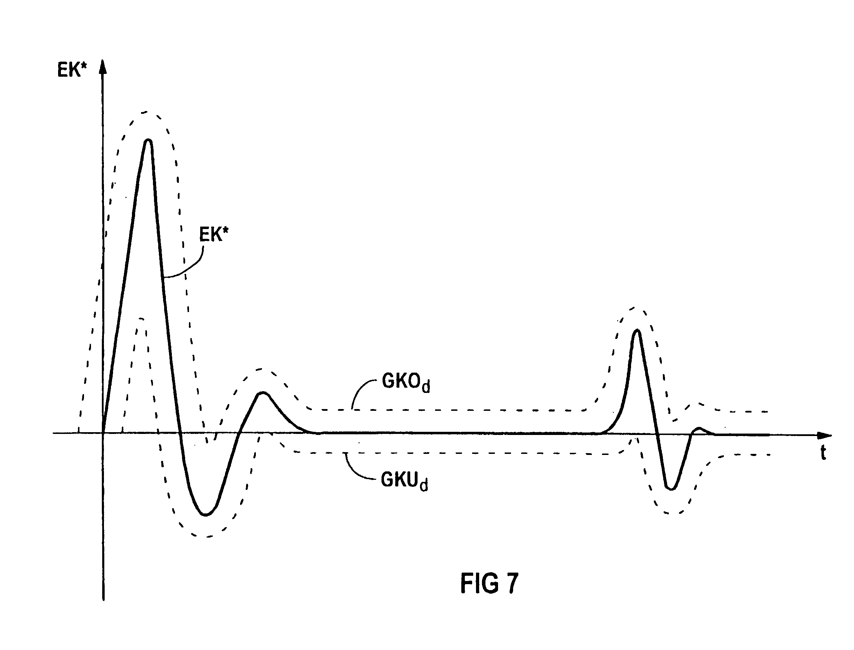

Neben der dynamischen Auswertung findet auch noch eine statische Auswertung statt. Bei dieser statischen Auswertung wird eine feste, zeitlich nicht veränderbare Soll-Echokurve EK*, die einer bestimmten Betriebssituation der Elektrodenleitung 4 zugeordnet ist, verwendet. Diese statische Soll Echokurve EK* wird mittels einer oberhalb und unterhalb verlaufenden Grenzkurve GKO_{d} und GKU_{d} gebildeten Toleranzband gemäß der Darstellung nach FIG 7 umhüllt. Bei der statischen Auswertung wird eine gebildete dynamische Soll-Echokurve derart mit der statischen Soll-Echokurve EK* verglichen, um herauszubekommen, ob diese dynamische Soll-Echokurve noch innerhalb des gebildeten Toleranzbandes liegt. Trifft dies innerhalb eines vorgegebenen Zeitraumes wenigstens einmal nicht zu, wird ein Fehlersignal generiert. Sobald ein Fehlersignal generiert ist, wird die Vorrichtung 2 zur Überwachung einer Elektrodenleitung 4 abgeschaltet, bis diese manuell wieder zurückgesetzt wird. Mit der Generierung eines Fehlersignals wird die momentane dynamische Soll-Echokurve sowie eine Anzahl von vorangegangen Ist-Echokurven zur Dokumentationszwecken im Dokumentationsspeicher 98 zwischengespeichert.

Die Einstellung des Toleranzbandes der statischen Soll-Echokurve EK* und die Einstellung des Toleranzbandes der Echodifferenzkurve wird mittels Einstellparameter vorgenommen. Der Aufruf einer statischen Soll-Echokurve EK*, die zu einer bestimmten Betriebssituation der Elektrodenleitung 4 gehört, wird mittels Betriebsparameter bewerkstelligt. Voraussetzung ist, daß im Hauptspeicher 92 mehrere statische Soll-Echokurven EK* abgespeichert sind.

## Patentansprüche

1. Verfahren zur elektrischen Überwachung einer Elektrodenleitung (4) einer bipolaren Hochspannungs-Gleichstrom-Übertragungs-Anlage, wobei diese Elektrodenleitung (4) von einem Verzweigungspunkt (18) an in zwei Leitungen (20,22) aufgeteilt ist, mit folgenden Verfahrensschritten:
a) Generierung eines bezüglich des Erdpotentials unsymmetrischen elektrischen Impulssignals (u(t)) und Aussendung des generierten Impulssignals sowie eines Trigger-Signals (S_{T}) bei Aussendung des Impulssignals,
b) Umwandlung des ausgesendeten unsymmetrischen Impulssignals (u(t)) in ein bezüglich des Erdpotentials symmetrisches Impulssignal im Gegentaktmode,
c) Einkopplung des Gegentaktmode-Impulssignals in die beiden Leitungen (20,22) der Elektrodenleituhg (4),
d) Bildung einer dynamischen Soll-Echo-Kurve durch Aufzeichnung einer sich aufgrund der Einkopplung des Gegenkontaktmode-Impulssignals ergebenden Ist-Echo-Kurve,
e) Bildung einer Ist-Echokurve (EK) durch Echtzeit-Aufzeichnung eines sich aufgrund der Einkopplung eines weiteren Gegentaktmode-Impulssignals ergebenden Echosignals für eine vorbestimmte Zeit,
f) Bildung einer Echodifferenzkurve (EDK) durch Bildung der Differenz aus der aufgezeichneten Ist-Echokurve (EK) und der dynamischen Soll-Echokurve,
g) Überprüfung der Echodifferenzkurve (EDK) auf Amplituden, die aus einem von zwei vorbestimmten, symmetrisch zur Zeitachse angeordneten Konstant-Grenzkurven (GKO,GKU) gebildeten Toleranzband herausragen,
h) Generierung eines Fehlersignals, sobald wenigstens eine Überschreitung des Toleranzbandes vorliegt und
i) Abschaltung der Impuls-Generierung, sobald ein Fehlersignal vorliegt.

2. Verfahren nach Anspruch 1, wobei zur Generierung der dynamischen Soll-Echokurve fortlaufend aus wenigstens zwei zeitlich aufeinanderfolgenden Ist-Echokurven (EK₁, EK₂, EK₃) eines fehlerfreien Betriebes der Elektrodenleitung (4) eine Mittelwert-Echokurve gebildet wird, die als Soll-Echokurve abgespeichert wird.

3. Verfahren nach Anspruch 1 oder 2, wobei zusätzlich zur dynamischen Soll-Echokurve eine vorbestimmte statische Soll-Echokurve (EK*) gebildet und diese statische Soll-Echokurve mit einem von einer oberhalb und unterhalb verlaufenden Grenzkurve (GKO_{d}, GKU_{d}) gebildeten Toleranzband umhüllt wird,
wobei in Abhängigkeit dieses Toleranzbandes überprüft wird, ob eine gebildete dynamische Soll-Echokurve noch innerhalb des Toleranzbandes der statischen Soll-Echokurve (EK*) verläuft,
wobei ein Fehlersignal generiert wird, sobald innerhalb eines vorgegebenen Zeitraumes wenigstens einmal eine Amplitude der zu überprüfenden dynamischen Soll-Echokurve außerhalb des Toleranzbandes liegt,
und wobei infolge des Fehlersignals die Impuls-Generierung und wobei infolge des Fehlersignals die Impuls-Generierung abgeschaltet wird.

4. Verfahren nach Anspruch 3, wobei das Toleranzband der statischen Soll-Echokurve (EK*) in Abhängigkeit von vorbestimmten Betriebsparametern der Elektrodenleitung (4) generiert wird.

5. Verfahren nach Anspruch 3 oder 4, wobei für unterschiedliche Betriebsbedingungen jeweils eine statische Soll-Echokurve (EK*) mit zugehörigem Toleranzband erzeugt und hinterlegt wird.

6. Verfahren nach einem der Ansprüche 1 bis 5, wobei das symmetrische Impulssignal im Gegentaktmode in einer Entfernung (a) von näherungsweise 1/4 einer Freiraurnwellenlänge (λ) der Mittenfrequenz des generierten unsymmetrischen Impulssignals (u(t)) vom Verzweigungspunkt (18) der Elektrodenleitung (4) in die beiden Leitungen (20,22) eingespeist wird.

7. Verfahren nach einem der Ansprüche 1 bis 6, wobei das unsymmetrische Impulssignal (u(t)) periodisch generiert wird.

8. verfahren nach einem der vorgenannten Ansprüche 1 bis 7, wobei als unsymmetrisches Impulssignal (u(t)) ein gleichanteilsfreies Impulssignal generiert wird.

9. Verfahren nach einem der Ansprüche 1 bis 8, wobei mit der Generierung eines Fehlersignals die momentane dynamische Soll-Echokurve und die momentanen aufgezeichnete Ist-Echokurve (EK) zu Dokumentationszwecken abgespeichert werden.

10. Verfahren nach einem der Ansprüche 1 bis 9, wobei fortlaufend eine vorbestimmte Anzahl von aufgezeichneten Ist-Echokurven (EK₁, EK₂, EK₃) zu Dokumentationszwecken abgespeichert wird.

11. Vorrichtung (2) zur elektrischen Überwachung einer von einem Verzweigungspunkt (18) an in zwei Leitungen (20,22) aufgeteilten Elektrodenleitung (4) einer bipolaren Hochspannungs-Gleichstrom-Übertragungs-Anlage unter Anwendung des Verfahrens nach einem der Ansprüche 1 bis 10,
mit einem Impuls-Echo-Überwachungsgerät (24) und einer Einspeisevorrichtung (26),
wobei das Impuls-Echo-Überwachungsgerät (24) einen Impuls-Generator (28) und eine Empfängereinrichtung (30) aufweist und ausgangsseitig mit den Eingangs-Anschlüssen der Einspeisevorrichtung (26) verbunden ist,
wobei weiterhin die Einspeisevorrichtung (26) ausgangsseitig jeweils mit einem Einspeiseanschluß (36,38) der Leitungen (20,22) der Elektrodenleitung (4) verbunden ist und die Einspeisevorrichtung (26) eine Einrichtung (25) zur Impulsumwandlung sowie zwei Koppelkondensatoren (30, 52) aufweist, welche die Ausgänge der Einrichtung (25) zur Impulsumwandlung mit den Ausgängen der Einspeiseschaltung (26) verbinden. (Figur 1)

12. Vorrichtung (2) nach Anspruch 11, wobei als Einrichtung (25) zur Impulsumwandlung ein Trennübertrager (44) vorgesehen ist, der eine Niederspannungs- und zwei Hochspannungswicklungen (62,58,60) aufweist, deren Verbindungspunkt (64) mit Erdpotential verbunden ist. (Figur 1)

13. Vorrichtung (2) nach Anspruch 11, wobei als Einrichtung (25) zur Impulsumwandlung ein Trennübertrager (44) zwei Spulen (46,48) und zwei Ableiter (54,56) vorgesehen sind, wobei jeweils eine Spule (46,48) und ein Ableiter (54,56) elektrisch parallel zu einer Hochspannungswicklung (58,60) geschaltet ist. (Figur 1)

14. Vorrichtung (2) nach einem der Ansprüche 11 bis 13, bei der der Impuls-Generator (28) zwei Spannungsquellen (66,68), zwei Kondensatoren (70,72), zwei Schalter (74,76), zwei Widerstände (78,80) und eine Betätigungseinrichtung (82) für die Schalter (74,76) aufweist,
wobei jeder Kondensator (70,72) mittels eines Widerstandes (78,80) mit einer Spannungsquelle (66,68) elektrisch leitend verbunden ist,
wobei ein Verbindungspunkt (84) der beiden Kondensatoren (70,72) und ein Verbindungspunkt (86) der beiden Spannungsquellen (66,68) jeweils mit Erdpotential verbunden sind,
wobei die Kondensatoren (70,72) jeweils mittels eines Schalters (74,76) mit dem Ausgang des Impuls-Generators (28) verbindbar sind,
und wobei die Betätigungseinrichtung (82) mit einem Steuer-Ausgang des Impuls-Generators (28) verbunden ist. (Figur 2)

15. Vorrichtung (2) nach einem der Ansprüche 11 bis 14, bei der die Empvängereinrichtung (30) eine Vorrichtung (88) zur Echtzeit-Aufzeichnung von Echosignalen, eine Recheneinheit (90), einen Hauptspeicher (92) und eine Eingangs- und Ausgangsschnittstelle (94,96) aufweist und bei der der Steuer-Eingang der Empfängereinrichtung (30) mit einem Steuer-Eingang der Vorrichtung (88) zur Echtzeit-Aufzeichnung von Echosignalen verbunden ist,
wobei die Recheneinheit (90) mit dem Hauptspeicher (92), der Vorrichtung (88) zur Echtzeit-Aufzeichnung und mit den Schnittstellen (94,96) verknüpft ist,
wobei der Signal-Eingang der Vorrichtung (88) zur Echtzeit-Aufzeichnung mit dem Eingang der Empfängereinrichtung (30) verbunden ist
und wobei eine übergeordnete Anlage-Steuerung ein- und ausgangsseitig mit der Aus- und Eingangsschnittstelle (96,94) verknüpft ist. (Figur 4)

16. Vorrichtung (2) nach einem der vorgenannten Ansprüche 11 bis 15, wobei die Einspeiseanschlüsse (36,38) der Leitungen (20,22) der Elektrodenleitung (4) jeweils in einem Abstand (a) vom Verzweigungspunkt (18) der Elektrodenleitung (4) angeordnet sind. (Figur 1)

17. Vorrichtung (2) nach Anspruch 16, wobei der Abstand (a) gleich ein Viertel der Wellenlänge (λ) einer Freiraumwellenlänge bei der Mittenfrequenz des Impulses (u(t)) ist.

18. Vorrichtung (2) nach einem der vorgenannten Ansprüche 11 bis 17, wobei die Einspeiseanschlüsse (36,38) jeweils mittels eines Ableiters (40,42) mit Erdpotential verbunden sind. (Figur 1)

19. Vorrichtung (2) nach einem der Ansprüche 11 bis 18, wobei der Impuls-Generator (28) und die Empfängereinrichtung (30) ein Impuls-Echo-Überwachungsgerät (24) bildet. (Figur 1)

20. Vorrichtung (2) nach einem der vorgenannten Ansprüche 11 bis 19, wobei als Verbindungsleitung zwischen Impuls-Generator (28) und Einspeisevorrichtung (26) und zwischen Einspeisevorrichtung (26) und Empfängereinrichtung (30) ein Koaxialkabel (32) vorgesehen ist. (Figur 1)

21. Vorrichtung (2) nach Anspruch 20, wobei das Koaxialkabel (32) doppelt geschirmt ist.

22. Vorrichtung (2) nach Anspruch 15, wobei die Vorrichtung (28) zur Echtzeit-Aufzeichnung einen Analog-Digital-Wandler mit nachgeschalteten Speicher aufweist.

23. Vorrichtung (2) nach Anspruch 15, wobei die Empfängereinrichtung (30) einen Dokumentationsspeicher (98) aufweist, der mit der Recheneinheit (90) verbunden ist. (Figur 1)

24. Vorrichtung (2) nach Anspruch 15 oder 23, wobei die Empfängereinrichtung (30) einen Bildschirm (100) aufweist, der eingangsseitig mit der Recheneinheit (90) verbunden ist. (Figur 4)

## Claims

1. Method for electrically monitoring an electrode line (4) of a bipolar high-voltage DC transmission system, this electrode line (4) being split up from a branch point (18) on into two lines (20, 22), having the following method steps:
a) generating an electric pulse signal (u(t)) unbalanced with reference to earth potential, and emitting the generated pulse signal and a trigger signal (S_{T}) when emitting the pulse signal,
b) converting this emitted unbalanced pulse signal (u(t)) into a pulse signal balanced with reference to earth potential in push-pull mode,
c) injecting the push-pull mode pulse signal into the two lines (20, 22) of the electrode line (4),
d) forming a dynamic desired echo curve by recording an actual echo curve resulting from the injection of the push-pull mode pulse signal,
e) forming an actual echo curve (EK) by real time recording of an echo signal resulting from the injection of a further push-pull mode pulse signal for a predetermined time,
f) forming an echo difference curve (EDK) by forming the difference from the recorded actual echo curve (EK) and the dynamic desired echo curve,
g) checking the echo difference curve (EDK) for amplitudes which project from a tolerance band formed by two predetermined constant limit curves (GKO, GKU) arranged symmetrically relative to the time axis,
h) generating a fault signal as soon as at least one overshoot of the tolerance band is available, and
i) switching off the pulse generation as soon as a fault signal is present.

2. Method according to Claim 1, it being the case that for the purpose of generating the dynamic desired echo curve a mean-value echo curve which is stored as a desired echo curve is formed continuously from at least two temporary successive actual echo curves (EK₁, EK₂, EK₃) of an error-free operation of the electrode line (4).

3. Method according to Claim 1 or 2, it being the case that in addition to the dynamic desired echo curve a predetermined static desired echo curve (EK*) is formed, and this static desired echo curve is enveloped by a tolerance band formed by a limit curve (GKO_{d}, GKU_{d}) running above and below,
a check being made, depending on this tolerance band, as to whether a formed dynamic desired echo curve still runs inside the tolerance band of the static desired echo curve (EK*),
a fault signal being generated as soon as an amplitude of the dynamic desired echo curve to be checked is outside the tolerance band at least once within a prescribed time interval,
and the pulse generation being switched off as a consequence of the fault signal.

4. Method according to Claim 3, the tolerance band of the static desired echo curve (EK*) being generated as a function of predetermined operating parameters of the electrode line (4).

5. Method according to Claim 3 or 4, a static desired echo curve (EK*) with associated tolerance band in each case being generated and stored for different operating conditions.

6. Method according to one of Claims 1 to 5, the balanced pulse-signal in push-pull mode being fed into the two lines (20, 22) at a distance (a) of approximately 1/4 of a free-space wavelength (λ) of the centre frequency of the generated unbalanced pulse signal (u(t)) from the branch point (18) of the electrode line (4).

7. Method according to one of Claims 1 to 6, the unbalanced pulse signal (u(t)) being generated periodically.

8. Method according to one of the previously mentioned Claims 1 to 7, a pulse signal with no direct components is generated as the unbalanced pulse signal (u(t)).

9. Method according to one of Claims 1 to 8, the instantaneous dynamic desired echo curve and the instantaneous recorded actual echo curve (EK) being stored for documentation purposes with the generation of a fault signal.

10. Method according to one of Claims 1 to 9, a predetermined number of recorded actual echo curves (EK₁, EK₂, EK₃) being stored continuously for documentation purposes.

11. Device (2) for electrically monitoring an electrode line (4) of a bipolar high-voltage DC transmission system, this electrode line (4) being split up from a branch point (18) into two lines (20, 22), by using the method according to one of Claims 1 to 10,
having a pulse-echo monitoring unit (24), and a feed device (26),
the pulse-echo monitoring unit (24) having a pulse generator (28) and a receiving device (30) and being connected on the output side to the input terminals of the feed device (26),
the feed device (26) being connected, furthermore, respectively on the output side to a feed terminal (36, 38) of the lines (20, 22) of the electrode line (4), and the feed device (26) having a device (25) for pulse conversion and two coupling capacitors (50, 52) which connect the outputs of the device (25) for pulse conversion to the outputs of the feed circuit (26). (Figure 1)

12. Device (2) according to Claim 11, there being provided as device (25) for pulse conversion an isolating transformer (44) which has one low-voltage and two high-voltage windings (62, 58, 60) whose tie point (64) is connected to earth potential. (Figure 1)

13. Device (2) according to Claim 11, an isolating transformer (44), two coils (46, 48) and two arrestors (54, 56) being provided as device (25) for pulse conversion, one coil (46, 48) and one arrestor (54, 56) in each case being connected electrically in parallel with a high-voltage winding (58, 60). (Figure 1)

14. Device (2) according to one of Claims 11 to 13, in which the pulse generator (28) has two voltage sources (66, 68), two capacitors (70, 72), two switches (74, 76), two resistors (78, 80) and an operating device (82) for the switches (74, 76),
each capacitor (70, 72) being connected in an electrically conducting fashion to a voltage source (66, 68) by means of a resistor (78, 80),
a tie point (84) of the two capacitors (70, 72), and a tie point (86) of the two voltage sources (66, 68) being connected in each case to earth potential,
it being possible for the capacitors (70, 72) to be connected to the output of the pulse generator (28) by means of a switch (74, 76) in each case,
and the operating device (82) being connected to a control output of the pulse generator (28). (Figure 2)

15. Device (2) according to one of Claims 11 to 14, in which the receiving device (30) has a device (88) for real time recording of echo signals, an arithmetic unit (90), a main memory (92) and input and output interfaces (94, 96) and in which the control input of the receiving device (30) is connected to a control input of the device (88) for real time recording of echo signals,
the arithmetic unit (90) being connected to the main memory (92), the device (88) for real time recording and to the interfaces (94, 96),
the signal input of the device (88) for real time recording being connected to the input of the receiving device (30),
and a higher order system controller being connected on the input and output sides to the output and input interfaces (96, 94). (Figure 4)

16. Device (2) according to one of the previously mentioned Claims 11 to 15, the feed terminals (36, 38) of the lines (20, 22) of the electrode line (4) being arranged in each case at a spacing (a) from the branch point (18) of the electrode line (4). (Figure 1)

17. Device (2) according to Claim 16, the spacing (a) being equal to a quarter of the wavelength (λ) of a free-space wavelength at the centre frequency of the pulse (u(t)).

18. Device (2) according to one of the previously mentioned Claims 11 to 17, the feed terminals (36, 38) being connected to earth potential by means of an arrestor (40, 42) in each case. (Figure 1)

19. Device (2) according to one of Claims 11 to 18, the pulse generator (28) and the receiving device (30) forming a pulse-echo monitoring unit (24). (Figure 1)

20. Device (2) according to one of the previously mentioned Claims 11 to 19, a coaxial cable (32) being provided as connecting line between the pulse generator (28) and feed device (26) and between the feed device (26) and receiving device (30). (Figure 1)

21. Device (2) according to Claim 20, the coaxial cable (32) being doubly shielded.

22. Device (2) according to Claim 15, the device (28) for real time recording having an analogue-to-digital converter with downstream memory.

23. Device (2) according to Claim 15, the receiving device (30) having a documentation memory (98) which is connected to the arithmetic unit (90). (Figure 1)

24. Device (2) according to Claim 15 or 23, the receiving device (30) having a display screen (100) which is connected on the input side to the arithmetic unit (90). (Figure 4)

## Revendications

1. Procédé de surveillance électrique d'une ligne d'électrodes (4) d'une installation bipolaire de transmission en courant continu à haute tension, cette ligne d'électrodes (4) étant divisée à partir d'un point d'embranchement (18) en deux lignes (20, 22), lequel procédé comprend les étapes opératoires suivantes consistant à:
a) générer un signal électrique impulsionnel (u(t)) asymétrique par rapport au potentiel de la terre et émettre le signal impulsionnel généré ainsi qu'un signal de déclenchement (S_{T}) lors de l'émission du signal impulsionnel,
b) convertir le signal impulsionnel asymétrique émis (u(t)) en un signal impulsionnel symétrique par rapport au potentiel de la terre en mode symétrique,
c) injecter le signal impulsionnel en mode symétrique dans les deux lignes (20, 22) de la ligne d'électrode (4),
d) former une courbe d'écho de consigne dynamique en traçant une courbe d'écho réelle obtenue en se fondant sur l'injection du signal impulsionnel en mode symétrique,
e) former une courbe d'écho réelle (EK) en traçant en temps réel et pendant un temps prédéterminé un signal d'écho obtenu en se fondant sur l'injection d'un autre signal impulsionnel en mode symétrique,
f) former une courbe de différence d'écho (EDK) en formant la différence entre la courbe d'écho réelle tracée (EK) et la courbe d'écho de consigne dynamique,
g) vérifier sur la courbe de différence d'écho les amplitudes qui sortent d'une bande tolérance formée par deux courbes limites constantes prédéterminées (GKO, GKU) situées symétriquement par rapport à l'axe des temps,
h) générer un signal d'erreur en présence d'au moins un dépassement par le haut de la bande de tolérance et
i) faire cesser la génération des impulsions dès qu'un signal d'erreur apparaît.

2. Procédé selon la revendication 1, dans lequel afin de générer la courbe d'écho de consigne dynamique, une courbe d'écho moyenne, qui est mémorisée en tant que courbe d'écho de consigne, est formée en continu à partir d'au moins deux courbes d'écho réelles (EK₁, EK₂, EK₃), se suivant temporellement, d'un fonctionnement sans erreur de la ligne d'électrode.

3. Procédé selon la revendication 1 ou 2, dans lequel
une courbe d'écho de consigne statique prédéterminée en plus de la courbe d'écho de consigne dynamique et cette courbe d'écho de consigne statique est enveloppée par une bande de tolérance formée par des courbes limites supérieure et inférieure (GKO_{d}, GKU_{d}),
on vérifie en fonction de cette bande de tolérance si une courbe d'écho de consigne dynamique formée se trouve encore à l'intérieur de la bande de tolérance de la courbe d'écho de consigne statique (EK*),
un signal d'erreur étant généré dès que, dans un intervalle de temps prédéterminé une amplitude de la courbe d'écho de consigne dynamique à vérifier se trouve au moins une fois à l'extérieur de la bande de tolérance,
et on fait cesser la génération des impulsions en cas de signal d'erreur.

4. Procédé selon la revendication 3, dans lequel la bande de tolérance de la courbe d'écho de consigne statique (EK*) est générée en fonction de paramètres de fonctionnement prédéterminés de la ligne d'électrodes (4).

5. Procédé selon la revendication 3 ou 4, dans lequel une courbe d'écho de consigne statique (EK*), à laquelle est associée une bande tolérance, est générée et mémorisée respectivement pour des conditions différentes de fonctionnement.

6. Procédé selon l'une des revendications 1 à 5, dans lequel le signal impulsionnel symétrique en mode symétrique est injecté dans les deux lignes (20, 22) à une distance (a) du point d'embranchement (18) de la ligne d'électrodes (4) correspondant approximativement à ¼ d'une longueur d'onde en espace libre (λ) de la fréquence moyenne du signal impulsionnel asymétrie généré (u(t)).

7. Procédé selon l'une des revendications 1 à 6, dans lequel le signal impulsionnel asymétrique (u(t)) est généré périodiquement.

8. Procédé selon l'une des revendications précédentes 1 à 7, dans lequel un signal impulsionnel sans composante continue est généré en tant que signal impulsionnel asymétrique (u(t)).

9. Procédé selon l'une des revendications 1 à 8, dans lequel la courbe d'écho de consigne dynamique instantanée et la courbe d'écho réelle tracée instantanément sont mémorisées avec la génération d'un signal d'erreur dans un but de documentation.

10. Procédé selon l'une des revendications 1 à 9, dans lequel un nombre prédéterminé de courbes d'écho réelles tracées (EK₁, EK₂, EK₃) sont mémorisées en continu dans un but de documentation.

11. Dispositif de surveillance électrique d'une ligne d'électrodes (4), divisée en deux lignes (20, 22) à partir d'un point d'embranchement (18), d'une installation bipolaire de transmission en courant continu à haute tension, lequel dispositif met en oeuvre le procédé selon l'une des revendications 1 à 10 et comporte un appareil de surveillance d'échos impulsionnels (24) et un dispositif d'injection (26),
l'appareil de surveillance d'échos impulsionnels (24) comportant un générateur d'impulsions (26) et un dispositif de réception (30) et étant relié en sortie aux bornes d'entrée du dispositif d'injection (26),
le dispositif d'injection (26) étant en outre relié en sortie à une borne d'injection (36, 38) des lignes (20, 22) de la ligne d'électrodes (4) et le dispositif d'injection (26) comportant un dispositif (25) de conversion d'impulsions ainsi que deux condensateurs de couplage (50, 52) qui relient les sorties du dispositif de conversion d'impulsions (25) aux sorties du circuit d'injection (26) (figure 1).

12. Dispositif (2) selon la revendication 11, dans lequel il est prévu comme dispositif de conversion d'impulsions (25) un transformateur séparateur (44) qui comporte un enroulement basse tension et deux enroulements haute tension (68, 58, 60) dont le point de liaison (64) est relié au potentiel de la terre (figure 1).

13. Dispositif (2) selon la revendication 11, dans lequel il est prévu comme dispositif de conversion d'impulsions (25) un transformateur séparateur (44), deux bobines (46, 48) et deux protection antisurtension (54, 56), une bobine (46, 48) et une protection antisurtension (54, 56) étant monté électriquement en parallèle avec un enroulement de haute tension (58, 60).

14. Dispositif (2) selon l'une des revendications 11 à 13, dans lequel le générateur d'impulsions (28) comporte deux sources de tension (66, 68), deux condensateurs (70, 72), deux interrupteurs (74, 76), deux résistances (78, 80) et un dispositif (82) de commande des interrupteurs (74, 76),
chaque condensateur (70, 72) étant relié électriquement au moyen d'une résistance (78, 80) à une source de tension (66, 68),
un point de liaison (84) des deux condensateurs (70, 72) et un point de liaison (86) des deux sources de tension (66, 68) étant reliés au potentiel de la terre,
les deux condensateurs (70, 72) pouvant être reliés au moyen d'un interrupteur (74, 76) à la sortie du générateur d'impulsions (28) et
le dispositif de commande (82) étant relié à une sortie de commande du générateur d'impulsions (28) (figure 2).

15. Dispositif (2) selon l'une des revendications 11 à 14, dans lequel le dispositif de réception (30) comporte un dispositif (88) destiné à tracer en temps réel des signaux d'écho, une unité de calcul (90), une mémoire principale (92) et une interface d'entrée et de sortie (94, 96) et dans lequel l'entrée de commande du dispositif de réception (30) est reliée à une entrée de commande du dispositif (88) de traçage en temps réel de signaux d'écho,
l'unité de calcul (90) étant combiné avec la mémoire principale (92), le dispositif (88) de traçage en temps réel et les interfaces (94, 96),
l'entrée de signal du dispositif de traçage en temps réel (88) étant reliée à l'entrée du dispositif de réception (30), et
une commande d'installation de niveau supérieur étant combinée du côté de l'entrée et de la sortie à l'interface d'entrée et de sortie (96, 94) (figure 4).

16. Dispositif (2) selon l'une des revendications précédentes 11 à 15, dans lequel les bornes d'injection (36, 38) des lignes (20, 22) de la ligne d'électrodes (4) sont situées à une distance (a) du point d'embranchement (18) de la ligne d'électrodes (4) (figure 1 ).

17. Dispositif (2) selon la revendication 16, dans lequel la distance (a) est égale à un quart de la longueur d'onde en espace libre (λ) à la fréquence moyenne de l'impulsion (u(t)).

18. Dispositif (2) selon l'une des revendications précédentes 11 à 17, dans lequel chacune des bornes d'injection (36, 38) est reliée via une protection antisurtension (40, 42) au potentiel de la terre (figure 1).

19. Dispositif (2) selon l'une des revendications 11 à 18, dans lequel le générateur d'impulsions (28) et le dispositif de réception (30) forme un dispositif de surveillance des échos d'impulsion (24) (figure 1).

20. Dispositif (2) selon l'une des revendications précédentes 11 à 19, dans lequel un câble coaxial (32) est prévu comme ligne de liaison entre le générateur d'impulsions (28) et le dispositif d'injection (26) et entre le dispositif d'injection (26) et le dispositif de réception (36) (figure 1).

21. Dispositif (2) selon la revendication 20, dans lequel le câble coaxial (32) comporte un double blindage.

22. Dispositif (2) selon la revendication 15, dans lequel le dispositif de traçage en temps réel (28) comporte un convertisseur analogique/numérique en aval duquel est monté une mémoire.

23. Dispositif (2) selon la revendication 15, dans lequel le dispositif de réception (30) comporte une mémoire de documentation (98) qui est reliée à l'unité de calcul (90) (figure 1).

24. Dispositif (2) selon la revendication 15 ou 23, dans lequel le dispositif de réception (30) comporte un écran (100) qui est relié du côté de l'entrée à l'unité de calcul (90) (figure 4).
